# EUROPÄISCHE PATENTSCHRIFT

(11) **EP 0 698 233 B1**
(45) Veröffentlichungstag und Bekanntmachung des Hinweises auf die Patenterteilung: **21.10.1998**
(21) Anmeldenummer: 94913199.9
(22) Anmeldetag: 10.05.1994
(51) Int. Cl.: G03F 7/16, B05D 3/02, B05D 3/06

(54) **VERFAHREN UND VORRICHTUNG ZUM BESCHICHTEN VON LEITERPLATTEN**
PROCESS AND DEVICE FOR COATING PRINTED CIRCUIT BOARDS
PROCEDE ET DISPOSITIF DE REVETEMENT DE PLAQUETTES DE CIRCUITS IMPRIMES

(30) Priorität: 12.05.1993 DE 4315774; 22.07.1993 DE 4324585; 03.09.1993 DE 4329730; 03.09.1993 DE 4329731; 08.11.1993 DE 4337907; 24.01.1994 DE 4401778
(43) Veröffentlichungstag der Anmeldung: 28.02.1996
(73) Patentinhaber: Ciba Specialty Chemicals Holding Inc., 4057 Basel (CH)
(72) Erfinder: SCHÄFER, Hans-Jürgen, D-41749 Viersen (DE)
(74) Vertreter: Zumstein, Fritz, Dr.
(86) Internationale Anmeldenummer: IB9400102
(87) Internationale Veröffentlichungsnummer: WO9427190

(56) Entgegenhaltungen:
- WO-A-92/07679
- RESEARCH DISCLOSURE, Bd.336, Nr.024, 10. April 1992, EMSWORTH, GB ANONYMOUS 'Printed circuit board air track conveyor - transports clean panel using suspending air track, circulating and heating air cleaned with HEPA filter'
- RESEARCH DISCLOSURE, Bd.272, Nr.023, 10. Dezember 1986, EMSWORTH, GB ANONYMOUS 'Vacuum lamination of photosensitive dry film solder mask - having premature contact prevented between film and composite, which would cause entrapped air and wrinkles'
- IBM TECHNICAL DISCLOSURE BULLETIN, Bd.30, Nr.10, März 1988, NEW YORK, US Seiten 278 - 279 ANONYMOUS 'Photoresist Adhesion to Dry-Plated Card/Board by Controlled Thermal Method'

## Beschreibung

Die Erfindung betrifft ein Verfahren zum Beschichten von Leiterplatten mit einer durch elektromagnetische Strahlung, vorzugsweise UV-Strahlung, vernetzbaren Beschichtung gemäss Oberbegriff des Patentanspruchs 1. Die Erfindung betrifft auch eine dazu geeignete Vorrichtung gemäss Oberbegriff des Patentanspruchs 13.

Die Leiterplatte hat die Funktion, die leitende Verbindung zu den Bauelementen herzustellen. Mit der fortschreitenden Miniaturisierung wird die Zahlen der Anschlüsse immer grösser, sodass die Leiterplattentechnologie nicht nur die Mehrebenenschaltung hervorgebracht hat sondern die Leiterzüge immer schmaler, die Bohrlochdurchmesser immer kleiner und die Anzahl von Leiterzügen zwischen zwei Bohrungen immer grösser werden.

Mit der Entwicklung der oberflächenmontierten Bauteile (surface mounted devices) konnte eine weitere Reduzierung der erforderlichen Fläche erreicht werden. Dies führte zu Leiterbreiten von kleiner 100 µm, zu Bohrlochdurchmessern von 0.3-0.2 mm und zu Lötaugendurchmessern von nur noch bis zu 0.4 mm bei bis zu sieben Leiterzügen zwischen einem Bohlochraster von 2.54 mm. Gleichzeitig müssen immer mehr Anschlüsse pro integrierter Schaltung realisiert werden, was zu Rastern der Anschlusspads von 0.3-0.4 mm führt. Die aus der immer höheren Integrationsdichte resultierenden Probleme sind sehr komplex und erfordern eine umfassende Lösung. Sie beginnen zunächst bei der Leiterbilderzeugung.

Zur Herstellung eines Leiterbildes wird das gebohrte kupferkaschierte Basismaterial mit einem Positiv- oder Negativresist beschichtet. Während dies früher siebdruckfähige Aetzoder Galvanoresiste waren, so werden heute überwiegend Fotoresiste eingesetzt. Hierbei handelt es sich um Fest- bzw. Flüssigresiste. Diese werden entweder auf die Oberfläche auflaminiert (Festresiste) oder mit einer Giessmaschine bzw. mit Walzen aufgetragen (Flüssigresiste). Das Leiterbild wird nach dem Auflegen einer Maske beispielsweise durch Belichtung mit UV-Licht unter Polymerisation des Resistes fixiert und freientwickelt. Dies führt zu dem sogenannten Pattermplating-Prozess. Beim Pattermplating wird zunächst eine Maske aufgelegt und werden nur die leiterfreien Bereiche belichtet und entwickelt. Danach werden die Leiterzüge galvanisch aufgebaut und die gebohrten Kontaktierlöcher verkupfert. Nach der galvanischen Abscheidung der Leiter werden diese beispielsweise mit einer Zinnauflage versehen, der Galvanoresist wird enfernt und das Leiterbild geätzt. Da die Aetzgeschwindigkeit in allen Richtungen gleich ist, entspricht die Unterätzung etwa der Dicke der verwendeten Kupferfolie. Die im Ätzschritt des Patternplating-Prozesses auftretende Unterätzung stellt die Grenze für die grosstechnische Anwendung dieses Verfahrens dar. Ausserdem ist bedingt durch die Bad- bzw. Leiterplattengeometrie die Herstellung von Leitern gleicher Höhe oft nicht möglich.

Für die Feinstleitertechnologie wurde daher das sogenannte Panelplatingverfahren entwickelt Hierbei geht man von dem gebohrten, kupferkaschierten Basismaterial aus und verkupfert zuerst galvanisch die Leiterplattenfläche und die gebohrten Löcher, um eine gleichmässige Dicke der Kupferschicht zu erreichen. Anschliessend wird ein Trockenfilmresist auflaminiert, mit einer Maske belichtet und entwickelt.

Bei Feinstleitern kommt es jedoch häufig zu Einschnürungen, weil der Liniendruck der Laminierwalze Unebenheiten des Basismaterials nicht ausgleichen kann, sodass die Haftung des Trockenfilmresistes nicht überall gleich gross ist. Besonders wichtig ist es, dass auch die bereits verkupferten Bohrlöcher vor dem Aetzangriff geschützt werden. Dies geschieht durch das Ueberdecken der Bohrungen mit Resist, dem sogenannten "Tenten".

Die weitere Miniaturisierung und die Technologie der oberflächenmontierten Bauelemente führte zu sogenannten restringfreien Durchsteigerbohrungen. Hier kann die Technologie der Trockenfilmlaminierung nicht angewandt werden, da der Resistfilm ohne die sogenannten Restrings nicht mehr auf der Leiterplattenoberfläche befestigt werden kann. Um jedoch auch restringfreie Bohrungen mit Resist bedecken zu können und sie derart vor dem Ätzangriff zu schützen, wurde die sogenannte Elektrotauchlackierung gefunden, welche aus einem Lackierbad einen 5-15 µm dicken Resistfilm in Loch und auf der Leiterplattenoberfläche abscheidet. Dieses Verfahren ist jedoch sehr kostenintensiv und kann auf Grund der geringen Schichtdicke nur zusammen mit dem Panelplatingverfahren eingesetzt werden.

In der WO 93/14444 wird ein Heissbeschichtungsverfahren vorgeschlagen, das in der Anwendung eines bei Raumtemperatur hochviskosen, schmelzbaren Fotoresists beruht, der nach der Verflüssigung im Vorhanggiessverfahren auf gekühlte Leiterplatten aufgetragen wird. Der auf die gekühlten Leiterplatten auftreffende Fotoschmelzresist wird an den Bohrlochwandungen gekühlt, sodass er nicht in diese hineinlaufen kann und eine an der Lochwandung abgestützte Lochüberdeckung ausbildet. Während die Kühlung der Leiterplatten bei noch unstrukturierten Leiterplatten zu guten Ergebnissen führt, kann sie jedoch bei gekühlten Leiterplatten nicht angewendet werden. In diesem Fall wirken die Leiterzüge als Kühlrippen. Der auf die Leiterfläche auftreffende Fotoschmelzresist kühlt schlagartig ab, wobei die Luft zwischen den Leiterzügen eingeschlossen werden kann.

Es sind auch Verfahren bekannt, bei denen ein Beschichtungsmittel mit Hilfe von Stahlwalzen auf die Leiterplatten aufgebracht wird. Besonders wirtschaftlich ist die gleichzeitige doppelseitige Beschichtung der Leiterplatten in einer Walzenbeschichtungsanlage, die über zwei beheizte Auftragswalzen verfügt. Ueblicherweise werden hierzu Lacksysteme eingesetzt, die einen hohen Lösungsmittelanteil haben und eine niedrige Viskosität. Die Oberflächenspannung muss gering sein, damit der Lack gut verlaufen kann und keine Streifen ausbildet. Dieses beidseitige Beschichtungsverfahren setzt möglichst ebene Oberflächen der Leiterplatten voraus. Bei der Beschichtung von bereits mit Leiterzügen versehenen Leiterplatten kann es zu Abquetschungen über den Leitem kommen, so dass eine sichere Abdeckung nicht gewährleistet ist. Ausserdem werden oft die Hohlräume, die durch Unterätzung unter den Leiterflanken vorhanden sind, nicht mit Lack gefüllt, was zu Fehlstellen nach dem Löten führt und das Eindringen von Feuchtigkeit ermöglicht.

Aufgabe der vorliegenden Erfindung ist es daher, ein Beschichtungsverfahren zu schaffen, welches die Erzeugung von luftblasenfreien Beschichtungen erlaubt. Insbesondere soll das Verfahren die gleichzeitige beidseitige Beschichtung von Leiterplatten erlauben. Es soll auch möglich sein, Leiterplatten mit relativ hohen Leiterzügen zu beschichten und dabei gleichzeitig vorhandene Durchkontaktierungsbohrungen zuverlässig zu überdecken. Unterätzungen an Leiterflanken sollen vollständig mit Lack ausgefüllt werden. Die Oberfläche der Beschichtung soll nach dem Trocknen weitgehend klebfrei sein und eine Belichtung im Kontaktbelichtungsverfahren ermöglichen. Es soll auch eine Vorrichtung bereitgestellt werden, welche die Durchführung des erfindungsgemässen Verfahrens erlaubt.

Die Lösung all dieser und noch weiterer damit in Verbindung stehender Aufgaben erfolgt duch ein Verfahren und durch eine Vorrichtung gemäss den unabhängigen Patentansprüchen 1 bzw. 13. Besonders bevorzugte Varianten des erfindungsgemässen Verfahrens bzw. zugehörigen erfindungsgemässen Vorrichtung sind jeweils Gegenstand der entsprechenden abhängigen Verfahrens- bzw. Vorrichtungsansprüche. Insbesondere wird durch die Erfindung ein Verfahren zum Beschichten von Leiterplatten mit einem durch elektromagnetische Strahlung, vorzugsweise UV-Strahlung, vernetzbaren Beschichtungsmittel im Walzenbeschichtungsverfahren geschaffen, welches sich durch die folgenden Verfahrensschritte auszeichnet:
- ein fotopolymerisierbares, bei Raumtemperatur hochviskoses bis festes, schmelzbares, niedermolekulares Beschichtungsmittel mit einem mittleren Molekulargewicht von vorzugsweise 500-1500 wird aufgeschmolzen und der Auftragwalze einer Walzenbeschichtungsanlage zugeführt
- das Beschichtungsmittel wird mit einer Temperatur von etwa 60°C-110°C und einer Viskosität von etwa 1000-20'000 mPas in einer Dicke von etwa 10-200 µm auf die Leiterplattenoberfläche(n) aufgetragen, wobei
- die zu beschichtende Oberfläche der Leiterplatte vor der Beschichtung auf eine Temperatur von etwa 10°C-50°C oberhalb der Auftragtemperatur des Beschichtungsmittels vorgeheizt wird.

Das schmelzbare Beschichtungsmittel wird mit einer hohen Viskosität von 1000 bis 20'000 mPas unter hohem Anpressdruck vorzugsweise beidseitig mit beheizten gummierten Auftragswalzen mit einer Temperatur von 60°C bis 110°C auf beheizte Leiterplatten aufgetragen, die eine Temperatur von 10 bis 50°C über der Auftragswalzentemperatur haben. Diese hohe Viskosität auf der Auftragswalze verhindert ein Abquetschen über den Leitern. Der vorzugsweise beidseitig aufgebrachte hohe Liniendruck sorgt zusammen mit der auf der Leiterplatte abfallenden Viskosität des Beschichtungsmittels für eine vollständige Ausfüllung aller Hohlräume unter den Leitern. Das Beschichtungsmittel wird auf der heisseren Leiterplattenoberfläche noch weiter verflüssigt und fliesst zu den Leiterkanten und deckt diese optimal ab.

Durch das erfindungsgemässe Beschichtungsverfahren der Leiterplatten in einer Walzenbeschichtungsanlage mit einem schmelzbaren Beschichtungsmittel werden die bisherigen Probleme wie Abquetschungen des Beschichtungsmittels über den Leitern sowie Lufteinschlüsse und Hohlräume unter den Leitern beseitigt. Im Gegensatz zu dem in der WO 93/14444 beschriebenen Vorhanggiessverfahren auf gekühlte Leiterplatten können auch strukturierte Leiterplatten mit Leiterzügen zuverlässig in hoher Qualität beschichtet werden.

Die erfindungsgemässe Vorrichtung zum Beschichten von Leiterplatten mit einem durch elektromagnetische Strahlung, vorzugsweise UV-Strahlung, vernetzbaren Beschichtungsmittel ist eine Walzenbeschichtungsanlage mit wenigstens einer Auftragswalze und Einrichtungen zum Aufbringen des Beschichtungsmittels auf die Auftragswalze. Sie umfasst einen beheizbaren und temperierbaren Schmelztopf für ein fotopolymerisierbares, bei Raumtemperatur hochviskoses bis festes, schmelzbares, niedermolekulares Beschichtungsmittel mit einem mittleren Molekulargewicht von vorzugsweise 500-1500, von dem das aufgeschmolzene Beschichtungsmittel zur Auftragswalze sowie eine Vorwärmeinrichtung für die zu beschichtenden Oberfläche der Leiterplatten, in der die Leiterplattenoberfläche vor der Beschichtung auf eine Temperatur von etwa 10°C-50°C oberhalb der Auftragtemperatur des Beschichtungsmittels vorgeheizt wird, wobei die Temperatur der Leiterplattenoberfläche eine Temperatur von 70°C-160°C nicht überschreitet.

Durch die Verwendung einer gummierten Auftragswalze können die Unebenheiten von strukturierten Leiterplatten mit Leiterzügen noch besser ausgeglichen werden. Der Schmelzresist ist weitgehend lösungsmittelfrei und verfestigt bei Raumtemperatur im wesentlichen. Eine Aufheizvorrichtung vor der Walzenbeschichtungsanlage sorgt dafür, dass die Temperatur der Leiterplatte grösser ist als die Auftragstemperatur des Beschichtungsmittels, jedoch 160°C nicht überschreitet. Dadurch ist sichergestellt, dass das Beschichtungsmittel erst auf der Leiterplatte höheren Temperaturen ausgesetzt ist, dort seine Viskosität verringert, sodass es in die kleinsten Zwischenräume fliessen kann und alle Bereiche gut abdecken kann. Andererseits ist die Leiterplattentemperatur nicht so hoch, dass Bindungen des Beschichtungsmittels degradieren können. Die Auftragviskosität des Beschichtungsmittels ist jedoch so hoch, dass Durchkontaktierbohrungen zuverlässig abgedeckt werden.

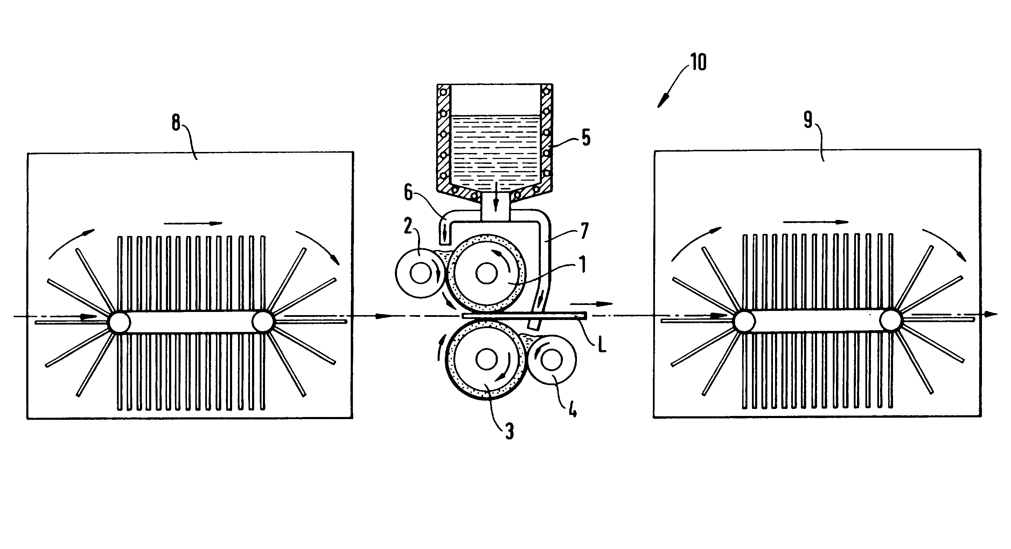

Im folgenden wird die Erfindung mit den ihr als wesentlich zugehörigen Einzelheiten unter Bezugnahme auf die einzige Figur, die eine schematische Darstellung einer erfindungsgemässen Walzenbeschichtungsanlage ist, näher erläutert.

Die Durchführung des erfindungsgemässen Verfahrens erfolgt mit einer Walzenbeschichtungsanlage. Je nach der gewünschten Beschichtungsart, einseitig oder beidseitig, kann es sich dabei um eine einzelne Walzenbeschichtungsanlage für einseitige Beschichtung handeln, oder es können zwei einseitige Walzenbeschichtungsanlagen hintereinandergeschaltet werden. Im letzteren Fall ist dann zwischen den Anlagen eine Wendestation angeordnet. Vorzugsweise wird für die beidseitige Beschichtung von Leiterplatten jedoch eine doppelseitige Walzenbeschichtungsanlage 10 eingesetzt, wie sie beispielsweise in der einzigen Figur dargestellt ist. Bei der dargestellten Anlage handelt es sich insbesondere um eine doppelseitige Walzenbeschichtungsanlage 10, welche für die gleichzeitige beidseitige Beschichtung der Leiterplatten ausgerüstet ist und über zwei beheizbare Auftragwalzen 1,3 verfügen. Die Auftragfläche der Auftragwalzen 1,3 ist vorzugsweise gummiert. Die Flexibilität der Gummierung ist dabei derart gewählt, dass Unebenheiten der Leiterplattenoberfläche, wie sie beispielsweise durch unterschiedlich hohe Leiterzüge verursacht werden, gut ausgeglichen werden können. Unmittelbar benachbart zu jeder Auftragwalze 1,3 ist eine gleichfalls beheizbare Dosierwalze 2,4 angeordnet. Dabei sind die Dosierwalzen derart angeordnet, dass jeweils zwischen der Dosierwalze 2,4 und der Auftragwalze ein schmaler Spalt freibleibt. Die Spaltweite definiert die Dicke des Beschichtungsmittelfilms, der sich auf der Auftragwalze 1,3 bildet. Zur Versorgung mit dem Beschichtungsmittel ist vorzugsweise oberhalb der Auftragswalzen 1,3 ein beheizbarer Vorratsbehälter 5 für das Beschichtungsmittel vorgesehen, von dem thermisch isolierte bzw. heizbare Versorgungsleitungen 6,7 zu den jeweiligen Walzenpaaren 1,2 bzw. 3,4 führen. Die obere und die untere Auftragwalze 1,3 sind vorzugsweise einen Abstand voneinander entfernt, der etwa 50%-95% der Leiterplattendicke entspricht.

Die Dosierspalte zwischen den auf 60°C-110°C beheizbaren gummierten Auftragswalzen 1,3 und den auf 70°C bis 160°C aufheizbaren Dosierwalzen 2,4 wird derart eingestellt, dass zwischen ihnen eine Lackwanne entsteht. Das bei Raumtemperatur hochviskose bis feste Beschichtungsmittel wird im Vorratsbehälter 5 soweit verflüssigt, dass es den beiden Walzenpaaren 1,2 bzw. 3,4 zugeführt werden kann. Zur Beschichtung werden die Leiterplatten L mit einer Geschwindigkeit von etwa 5-20 m/min durch den Durchtrittsspalt zwischen den beiden Auftragwalzen 1,3 hindurchtransportiert. Dadurch dass die Auftragwalzen und die Dosierwalzen beheizbar sind, kann das Beschichtungsmittel erst unmittelbar vor dem Auftrag auf die Leiterplattenoberfläche auf die erforderliche Auftragtemperatur und die erforderliche Auftragviskosität gebracht werden. Das verwendete schmelzbare Beschichtungsmittel weist dabei vorzugsweise einen Erweichungsbereich von etwa 20°C-80°C auf.

Vor der Beschichtung werden die Leiterplatten L in einer vor der Walzenbeschichtungsanlage 10 angeordneten Temperiereinrichtung 8 auf die gewünschte Beschichtungstemperatur gebracht. Insbesondere werden die Leiterplatten L vor der Beschichtung in der Temperiereinrichtung 8 derart aufgeheizt, so dass ihre Oberfläche eine um 10°C-50°C höhere Temperatur aufweist als das aufgetragene Beschichtungsmittel. Auf diese Weise wird erreicht, dass das Beschichtungsmittel auf der Leiterplattenoberfläche noch weiter verflüssigt wird, um Unebenheiten besser auszugleichen. Die Auftragsviskosität des Beschichtungsmittels beträgt dabei etwa 1000-20'000 mPas, vorzugsweise etwa 8000-12'000 mPas. Durch diese relativ hohe Auftragviskosität des Beschichtungsmittels ist gewährleistet, dass Durchkontaktierungsbohrungen gut mit dem Beschichtungsmittel überdeckt werden. Die Temperatur der Leiterplattenoberfläche ist so eingestellt, dass die Viskosität des Beschichtungsmittels über den Bohrungen nur gerade soweit herabgesetzt wird, dass das Beschichtungsmittel nicht abfliessen kann, sondern die Überdeckung erhalten bleibt.

In einer der Walzenbeschichtungsanlage 10 nachgeschalten Temperstation 9 werden die beschichteten Leiterplatten L gegebenenfalls getempert, um so eine klebfreie Oberfläche zu erzielen. Es kann aber auch eine Belichtungsstation nachgeschaltet sein, in der die beschichtete Leiterplattenoberfläche kurzfristig mit UV-Strahlung belichtet wird, um eine oberflächliche Vorvernetzung zu erreichen und so eine klebfreie Oberfläche zu erzielen. Auch eine Kombination von Temperstation 9 und Belichtungstation ist möglich.

Die Beschichtung kann als Ätz- bzw. Galvanoresist eingesetzt werden, der nach der entsprechenden Behandlung der Leiterplatten wieder entfernt wird. Sie kann aber auch als Permanentresist für Additivverfahren verwendet werden, als Lötstoppmaske oder als Maske für die Erstellung von hohen Lötdepots eingesetzt werden.

Die Erfindung soll anhand der nachfolgenden Beispiele näher erläutert werden. Zur Herstellung der verschiedenen beispielsweisen Beschichtungsmittel werden folgende Harzkomponenten eingesetzt:

Harzkomponente A: Mittels Strahlen vernetzbares, bei Raumtemperatur festes Harz mit einem mittleren Molekulargewicht von 860, einem Erweichungsbereich von 30 bis 40°C und einer Viskosität bei 70°C von 10000 bis 20000 mPa·s, das erhalten wird, indem man 1 Äquivalent eines Bisphenol A-diglycidylethers vom Molekulargewicht 188 bis 220 mit 1,1 Äquivalenten Acrylsäure umsetzt und anschliessend das Umsetzungsprodukt mit 0,8 Äquivalenten Hexahydrophthalsäureanhydrid zur Reaktion bringt, wobei die Umsetzung während 3 Stunden bei 80°C durchgeführt wird.

Harzkomponente B: Mittels Strahlen vernetzbares und thermisch härtbares Harz, welches bei Raumtemperatur fest ist und einen Erweichungspunkt von 20 bis 30°C hat und bei 80°C eine Viskosität von 2000 bis 5000 mPa·s aufweist. Dieses Harz wird erhalten, indem man 1 Mol eines Kresolnovolaktriglycidylethers mit einem Molekulargewicht von etwa 580 mit 1 Mol Acrylsäure umsetzt.

Harzkomponente B1: Mittels Strahlen vernetzbares Harz, das erhalten wird, indem man die oben beschriebene Harzkomponente B während 3 Stunden bei 60°C mit einem ungesättigten Isocyanatocarbamatester mit einem Molekulargewicht von 290 umsetzt, der durch Umsetzung von 1 Mol Toluylen-2,4- und -2,6-diisocyanat-Isomerengemisch mit 1 Mol Hydroxyethylacrylat gemäss EP-A-0 194 360, Beispiel 2, erhalten wurde. Die Harzkomponente B1 hat ein Molekuargewicht von 950, ein Epoxidäquivalent von 475, und die Viskosität beträgt bei Raumtemperatur 200'000 mPa·s und bei 70°C 500 bis 1000 mPa·s.

Harzkomponente C: Verlaufsmittel und einen Fotoinitiator enthaltender Kresolnovolak mit einem Molekulargewicht von 534 der folgenden Zusammensetzung:
60 Gewichtsteile Kresolnovolak mit einem Molekulargewicht von 460,
30 Gewichtsteile 2-Ethylanthrachinon,
5 Gewichtsteile Savinylblau und
5 Gewichtsteile Verlaufsmittel Byk®361.

Harzkomponente D: Verlaufsmittel, Fotoinitiator und Härtungsbeschleuniger enthaltender Kresolnovolak mit einem Molekulargewicht von 534 der folgenden Zusammensetzung:
50 Gewichtsteile Kresolnovolak mit einem Molekulargewicht von 460,
10 Gewichtsteile 2-Methylimidazol,
30 Gewichtsteile 2-Ethylanthrachinon,
5 Gewichtsteile Helio-echtgrün und
5 Gewichtsteile Verlaufsmittel Byk®361.

### Beispiel 1:

Es soll ein Ätz- bzw. Galvanoresist auf die Leiterplattenoberfläche(n) aufgetragen werden.

| | | |
|---|---|---|
| Leiterplatte | Basismaterial FR 4, Dicke | 1.6 mm |
| | Kupferkaschierung | 17.5 µm |
| | Temperatur | 120°C |

- Beschichtungsmittel 1:: 64 Gewichtsteile Harzkomponente A,
32 Gewichtsteile Harzkomponente B1,
3 Gewichtsteile 2-Ethylanthrachinon,
0,5 Gewichtsteile Verlaufsmittel Byk®361 und
0,5 Gewichtsteile Savinylblau.

Zur Erstellung eines Ätzresists bzw. eines Galvanoresists wird das Beschichtungsmittel 1 mit einer Walzenbeschichtungsanlage auf die Leiterplatten aufgetragen.
Auftragwalzentemperatur: 80°C
Auftragviskosität des Beschichtungsmittels 1: 1000 mPas

Beschichtungsdicke bei Ätzresist: 10 µm
Leiterplattentransportgeschwindigkeit bei Beschichtung: 20 m/min

Beschichtungsdicke bei Galvanoresist: 40 µm
Leiterplattentransportgeschwindigkeit bei Beschichtung: 10 m/min

Die beschichtete Leiterplatte wird in senkrechter Stellung während 3-10 min bei einer Temperatur von 110°C-120°C getempert. Dabei vorvernetzen die Komponenten der Beschichtung und ergeben nach dem Abkühlen der Leiterplatte auf Raumtemperatur eine klebfreie Oberfläche.

### Beispiel 2:

Im beidseitigen Walzenbeschichtungsverfahren wird eine bei Raumtemperatur feste Beschichtung auf die Leiterplattenoberflächen aufgetragen, die nach dem Abkühlen auf Raumtemperatur eine klebfreie Oberfläche ergibt.

| | | |
|---|---|---|
| Leiterplatte | Basismaterial FR 4, Dicke | 1.6 mm |
| | Kupferkaschierung | 17.5 µm |
| | Temperatur | 140°C |

- Beschichtungsmittel 2:: 90 Gewichtsteile Harzkomponente A und
10 Harzkomponente C.

Das schmelzbare Beschichtungsmittel wird zur Erstellung eines klebfreien Ätz- oder Galvanoresists aufgetragen.
Auftragwalzentemperatur: 110°C
Auftragviskosität des Beschichtungsmittels: 1000 mPas

Beschichtungsdicke bei Ätzresist: 10 µm
Leiterplattentransportgeschwindigkeit bei Beschichtung: 20 m/min

Beschichtungsdicke bei Galvanoresist: 40 µm
Leiterplattentransportgeschwindigkeit bei Beschichtung: 10 m/min

Die beschichteten Leiterplatten werden in senkrechter Stellung erkalten gelassen und besitzen bei Raumtemperatur eine klebfreie Oberfläche.

### Beispiel 3:

Es werden Lötstoppmasken in Dicken von 30 µm und 100 µm durch Auftrag eines bei Raumtemperatur festen und schmelzbaren Beschichtungsmittels im Walzenbeschichtungsverfahren hergestellt.

| | | |
|---|---|---|
| Leiterplatte | Basismaterial FR 4, Dicke: | 1.6 mm |
| | Leiterhöhe: | 60 µm |
| | Leiterbreite: | 100 µm |
| | Leiterabstand: | 150 µm |
| | Temperatur: | 90°C |

- Beschichtungsmittel 3:: 50 Gewichtsteile Harzkomponente A,
40 Gewichtsteile Harzkomponente B und
10 Gewichtsteile Harzkomponente D.

Auftragwalzentemperatur: 70°C
Auftragviskosität des Beschichtungsmittels 3: 10'000 mPas

Beschichtungsdicke: 30 µm
Transportgeschwindigkeit der Leiterplatten bei Beschichtung: 20 m/min

Beschichtungsdicke: 100 µm
Transportgeschwindigkeit der Leiterplatten bei Beschichtung: 15 m/min

Nach dem Beschichten erkalten die Leiterplatten in senkrechter Stellung auf Raumtemperatur. Ihre beschichtete Oberfläche ist bei Raumtemperatur klebfrei.

## Patentansprüche

1. Verfahren zum Beschichten von Leiterplatten mit einem durch elektromagnetische Strahlung, vorzugsweise UV-Strahlung, vernetzbaren Beschichtungsmittel im Walzenbeschichtungsverfahren, dadurch gekennzeichnet, dass
- ein fotopolymerisierbares, bei Raumtemperatur hochviskoses bis festes, schmelzbares, niedermolekulares Beschichtungsmittel mit einem mittleren Molekulargewicht von vorzugsweise 500-1500 aufgeschmolzen und der Auftragwalze einer Walzenbeschichtungsanlage zugeführt wird und
- das Beschichtungsmittel mit einer Temperatur von etwa 60°C-110°C und einer Viskosität von etwa 1000-20'000 mPas in einer Dicke von etwa 10-200 µm auf die Leiterplattenoberfläche(n) aufgetragen wird, wobei
- die zu beschichtenden Oberfläche der Leiterplatte vor der Beschichtung auf eine Temperatur von etwa 10°C-50°C oberhalb der Auftragtemperatur des Beschichtungsmittels vorgeheizt wird.

2. Verfahren nach Anspruch 1, dadurch gekennzeichnet, dass die Temperatur der zu beschichtenden Leiterplattenoberfläche auf etwa 70°C-160°C eingestellt wird.

3. Verfahren nach Anspruch 1 oder 2, dadurch gekennzeichnet, dass das Beschichtungsmittel erst unmittelbar vor dem Auftragen auf die Leiterplattenoberfläche(n), vorzugsweise durch beheizbare Auftragwalzen, auf Auftragtemperatur und Auftragviskosität gebracht wird.

4. Verfahren nach einem der vorangehenden Ansprüche, dadurch gekennzeichnet, dass der Durchtrittsspalt zwischen den Auftragwalzen der Walzenbeschichtungsanlage auf etwa 50%-95% der Leiterplattendicke eingestellt wird.

5. Verfahren nach einem der vorangehenden Ansprüche, dadurch gekennzeichnet, dass ein Beschichtungsmittel mit einem Erweichungsbereich von etwa 20°C-80°C eingesetzt wird.

6. Verfahren nach einem der vorangehenden Ansprüche, dadurch gekennzeichnet, dass beide Oberfächen der Leiterplatten beschichtet werden, wobei die Beschichtung vorzugsweise gleichzeitig erfolgt.

7. Verfahren nach einem der vorangehenden Ansprüche, dadurch gekennzeichnet, dass die Beschichtung nach dem Auftragen und vor der weiteren Bearbeitung durch einen Temperschritt oder eine kurze UV-Belichtung teilweise vernetzt wird, um eine nicht klebrige Oberfläche der Leiterplatte zu erzielen.

8. Verfahren nach einem der vorangehenden Ansprüche, dadurch gekennzeichnet, dass die Beschichtung eine Lötstoppmaske ergibt.

9. Verfahren nach einem der Ansprüche 1-8, dadurch gekennzeichnet, dass die Beschichtung als Maske für die Erstellung hoher Lötdepots eingesetzt wird.

10. Verfahren nach einem der Ansprüche 1-8, dadurch gekennzeichnet, dass die Beschichtung einen Ätz- bzw. Galvanoresist ergibt.

11. Verfahren nach einem der Ansprüche 1-8, dadurch gekennzeichnet, dass die Beschichtung einen Permanentresist für Additivverfahren ergibt.

12. Verfahren nach einem der vorangehenden Ansprüche, dadurch gekennzeichnet, dass die Beschichtung restringfreie Durchsteigeröffnungen überdeckt.

13. Vorrichtung zum Beschichten von Leiterplatten mit einem durch elektromagnetische Strahlung vorzugsweise UV-Strahlung, vernetzbaren Beschichtungsmittel mit Walzenbeschichtungsanlage, welche wenigstens eine Auftragswalze und Einrichtungen zum Aufbringen des Beschichtungsmittels auf die Auftragswalzen umfasst, dadurch gekennzeichnet, dass die Walzenbeschichtungsanlage mit einem beheizbaren und temperierbaren Schmelztopf für ein fotopolymerisierbares, bei Raumtemperatur hochviskoses bis festes, schmelzbares, niedermolekulares Beschichtungsmittel mit einem mittleren Molekulargewicht von vorzugsweise 500-1500 und ausgestattet ist, von dem das aufgeschmolzene Beschichtungsmittel zur Auftragswalze gefördert wird, und dass eine Vorwärmeinrichtung für die zu beschichtende Oberfläche der Leiterplatten vorgesehen ist, in der die Leiterplattenoberfläche vor der Beschichtung auf eine Temperatur von etwa 10°C-50°C oberhalb der Auftragtemperatur des Beschichtungsmittels vorgeheizt wird, wobei die Temperatur der Leiterplattenoberfläche eine Temperatur von 70°C-160°C nicht überschreitet.

14. Vorrichtung nach Anspruch 13, dadurch gekennzeichnet, dass die Walzenbeschichtungsanlage wenigstens eine beheizbare Auftragswalze umfasst, mit der das schmelzbare Beschichtungsmittel erst unmittelbar vor dem Auftragen auf die heissere Leiterplattenoberfläche auf eine Auftragtemperatur von etwa 60°C-110°C und auf eine Auftragviskosität von etwa 1000-20'000 mPas bringbar ist.

15. Vorrichtung nach Anspruch 13 oder 14, dadurch gekennzeichnet, dass Einrichtungen zum Aufbringen des Beschichtungsmittels auf die Auftragswalzen wenigstens eine Dosierwalze umfassen, welche beheizbar ist, und deren Temperatur auf vorzugsweise etwa 70°C-110°C einstellbar ist.

16. Vorrichtung nach einem der Ansprüche 13-15, dadurch gekennzeichnet, dass die Walzenbeschichtungsanlage zur gleichzeitigen beidseitigen Beschichtung der Leiterplatten ausgebildet ist und zwei beheizbare Dosierwalzen sowie zwei beheizbare Auftragwalzen umfasst, welche zwischen sich einen Durchtrittsspalt variabler Höhe freilassen, der etwa 50%-95% der Dicke der zu beschichtenden Leiterplatten beträgt.

17. Vorrichtung nach einem der Ansprüche 13-16, dadurch gekennzeichnet, dass im Anschluss an die Walzenbeschichtungsanlage eine Temperstation oder eine UV-Bestrahlungsstation angeordnet ist, in der die Beschichtung der Leiterplatte durch tempern oder durch kurzes Bestrahlen mit UV-Strahlung klebfrei machbar ist.

18. Vorrichtung nach einem der Ansprüche 13-17, dadurch gekennzeichnet, dass die Auftragswalze gummiert ist.

## Claims

1. A process for coating printed circuit boards with a coating composition that is crosslinkable by electromagnetic radiation, especially UV radiation, using the roll coating process, wherein
- a photopolymerisable, meltable, low-molecular-weight coating composition that is highly viscous to solid at room temperature and has an average molecular weight of preferably from 500 to 1500 is melted and fed to the applicator roll of a roll coating apparatus, and
- the coating composition is coated at a temperature of approximately from 60°C to 110°C and a viscosity of approximately from 1000 to 20 000 mPas on to the surface(s) of a printed circuit board in a thickness of approximately from 10 to 200 µm,
- the surface of the printed circuit board to be coated being pre-heated, prior to coating, to a temperature that is approximately from 10°C to 50°C higher than the application temperature of the coating composition.

2. A process according to claim 1, wherein the temperature of the surface of the printed circuit board to be coated is adjusted to approximately from 70°C to 160°C.

3. A process according to either claim 1 or claim 2, wherein the coating composition is brought to the application temperature and the application viscosity, preferably by means of heatable applicator rolls, only immediately before it is coated on to the surface(s) of the printed circuit board.

4. A process according to any one of the preceding claims, wherein the through-gap between the applicator rolls of the roll coating apparatus is adjusted to approximately from 50 % to 95 % of the thickness of the printed circuit board.

5. A process according to any one of the preceding claims, wherein a coating composition having a softening range of approximately from 20°C to 80°C is used.

6. A process according to any one of the preceding claims, wherein both surfaces of the printed circuit boards are coated, the coating preferably being carried out simultaneously.

7. A process according to any one of the preceding claims, wherein, after application and before further processing, the coating is partially crosslinked by a tempering step or brief exposure to UV radiation in order that the printed circuit board has a non-tacky surface.

8. A process according to any one of the preceding claims, wherein the coating produces a solder mask.

9. A process according to any one of claims 1 to 8, wherein the coating is used as a mask for the production of high solder deposits.

10. A process according to any one of claims 1 to 8, wherein the coating produces an etching or electro resist.

11. A process according to any one of claims 1 to 8, wherein the coating produces a permanent resist for additive processes.

12. A process according to any one of the preceding claims, wherein the coating covers rest-ring-free through-holes.

13. An apparatus for coating printed circuit boards with a coating composition that is crosslinkable by electromagnetic radiation, especially UV radiation, using a roll coating apparatus having at least one applicator roll and devices for applying the coating composition to the applicator rolls, wherein the roll coating apparatus is equipped with a melting vessel for a photopolymerisable, meltable, low-molecular-weight coating composition that is highly viscous to solid at room temperature and has an average molecular weight of preferably from 500 to 1500, which melting vessel can be heated and the temperature of which can be controlled and from which the melted coating composition is fed to the applicator roll, and wherein there is provided a device for pre-heating the surface of the printed circuit board that is to be coated, in which device the surface of the printed circuit board is pre-heated, prior to coating, to a temperature that is approximately from 10°C to 50°C higher than the application temperature of the coating composition, the temperature of the surface of the printed circuit board not exceeding a temperature of from 70°C to 160°C.

14. An apparatus according to claim 13, wherein the roll coating apparatus comprises at least one heatable applicator roll by means of which the meltable coating composition can be brought to an application temperature of approximately from 60°C to 110°C and an application viscosity of approximately from 1000 to 20 000 mPas only immediately before it is coated on to the hotter surface of the printed circuit board.

15. An apparatus according to either claim 13 or claim 14, wherein devices for applying the coating composition to the applicator rolls comprise at least one metering roll, which is heatable and the temperature of which can be adjusted to preferably approximately from 70°C to 110°C.

16. An apparatus according to any one of claims 13 to 15, wherein the roll coating apparatus is arranged for the simultaneous coating of both sides of the printed circuit boards and comprises two heatable metering rolls as well as two heatable applicator rolls, between which there is left a through-gap of variable width that is approximately from 50 % to 95 % of the thickness of the printed circuit boards to be coated.

17. An apparatus according to any one of claims 13 to 16, wherein there is arranged downstream of the roll coating apparatus a tempering station or a UV exposure station in which the coating of the printed circuit board can be rendered non-tacky by tempering or by brief exposure to UV radiation.

18. An apparatus according to any one of claims 13 to 17, wherein the applicator roll is rubberised.

## Revendications

1. Procédé de revêtement de circuits imprimés avec un produit de revêtement réticulable par un rayonnement électromagnétique, de préférence un rayonnement ultraviolet, en utilisant la technique d'application par rouleaux, caractérisé en ce que :
- On fait fondre un produit de revêtement de bas poids moléculaire, fusible, allant de hautement visqueux à solide à la température ambiante, photopolymérisable, ayant un poids moléculaire moyen de préférence compris entre 500 et 1500 et on l'amène au rouleau applicateur d'une installation de revêtement par rouleaux ;
- On dépose le produit de revêtement sur la ou les surfaces des circuits imprimés à une température de l'ordre de 60 °C à 110 °C et à une viscosité de l'ordre de 1000 à 20000 mPa·s avec une épaisseur de 10 à 200 µm environ ;
- la surface du circuit imprimé à revêtir étant préchauffée à une température supérieure d'environ 10 °C à 50 °C à la température d'application du produit de revêtement.

2. Procédé selon la revendication 1, caractérisé en ce que la température des surfaces des circuits imprimés à revêtir est ajustée entre 70 °C et 160 °C environ.

3. Procédé selon la revendication 1 ou la revendication 2, caractérisé en ce que le produit de revêtement est amené à la température et la viscosité nécessaires pour l'application juste avant d'être déposé sur la ou les surfaces des circuits imprimés, de préférence au moyen de rouleaux applicateurs chauffants.

4. Procédé selon l'une quelconque des revendications précédentes, caractérisé en ce que la fente de passage entre les rouleaux applicateurs de l'installation de revêtement à rouleaux est ajustée entre 50 % et 95 % de l'épaisseur des circuits imprimés.

5. Procédé selon l'une quelconque des revendications précédentes, caractérisé en ce que l'on utilise un produit de revêtement avec une plage de ramollissement de 20 °C à 80 °C environ.

6. Procédé selon l'une quelconque des revendications précédentes, caractérisé en ce que les deux surfaces des circuits imprimés sont revêtues, le revêtement s'effectuant de préférence simultanément.

7. Procédé selon l'une quelconque des revendications précédentes, caractérisé en ce que le revêtement est partiellement réticulé après son application et avant la poursuite du traitement au moyen d'une étape de conditionnement ou d'une brève insolation aux U.V. afin d'obtenir une surface des circuits imprimés non collante.

8. Procédé selon l'une quelconque des revendications précédentes, caractérisé en ce que le revêtement donne un masque épargne de gravure.

9. Procédé selon l'une quelconque des revendications 1 à 8, caractérisé en ce que le revêtement est utilisé comme masque servant à réaliser des dépôts de soudure épais.

10. Procédé selon l'une quelconque des revendications 1 à 8, caractérisé en ce que le revêtement donne un résist de gravure ou un résist de galvano.

11. Procédé selon l'une quelconque des revendications 1 à 8, caractérisé en ce que le revêtement donne un résist permanent pour le procédé additif.

12. Procédé selon l'une quelconque des revendications précédentes, caractérisé en ce que le revêtement recouvre des orifices de liaison sans anneau résiduel.

13. Dispositif de revêtement de circuits imprimés avec un produit de revêtement réticulable par un rayonnement électromagnétique, de préférence un rayonnement ultraviolet au moyen d'une installation de revêtement à rouleaux comprenant au moins un rouleau applicateur et des dispositifs d'alimentation du produit de revêtement sur les rouleaux applicateurs, caractérisé en ce que l'installation de revêtement à rouleaux est équipée d'une tête de fusion pouvant être chauffée et conditionnée pour un produit de revêtement de bas poids moléculaire, fusible, allant de hautement visqueux à solide à la température ambiante, photopolymérisable, ayant un poids moléculaire moyen de préférence compris entre 500 et 1500, tête à partir de laquelle le produit de revêtement en fusion est amené au rouleau applicateur, et en ce qu'il est prévu un dispositif de préchauffage pour les surfaces des circuits imprimés à revêtir dans lequel la surface des circuits imprimés est chauffée avant revêtement à une température supérieure de 10 °C à 50 °C environ à la température d'application du produit de revêtement, la température de la surface du circuit imprimé ne dépassant pas une valeur de 70 °C à 160 °C.

14. Dispositif selon la revendication 13, caractérisé en ce que l'installation de revêtement à rouleaux comprend au moins un rouleau applicateur chauffant grâce auquel le produit de revêtement fusible peut être porté à une température d'application de 60 °C à 110 °C environ et à une viscosité d'application de 1000 à 20.000 mPa.s environ juste avant d'être déposé sur la surface plus chaude du circuit imprimé.

15. Dispositif selon la revendication 13 ou la revendication 14, caractérisé en ce que les dispositifs servant à amener le produit de revêtement aux rouleaux applicateurs comprennent au moins un rouleau doseur qui peut être chauffé et dont la température peut être ajustée de préférence entre 70 °C et 110 °C environ.

16. Dispositif selon l'une quelconque des revendications 13 à 15, caractérisé en ce que l'installation de revêtement à rouleaux est conçue pour revêtir simultanément les deux faces des circuits imprimés et comprend deux rouleaux doseurs chauffants ainsi que deux rouleaux applicateurs chauffants entre lesquels est ménagée une fente de passage de hauteur variable, égale à 50 % à 95 % de l'épaisseur des circuits imprimés à revêtir.

17. Dispositif selon l'une quelconque des revendications 13 à 16, caractérisé en ce qu'il est prévu, disposé en série avec l'installation de revêtement à rouleaux, un poste de conditionnement ou un poste d'insolation aux U.V. dans lequel le revêtement des circuits imprimés peut être rendu non collant par un conditionnement thermique ou par une brève insolation aux U.V..

18. Dispositif selon l'une quelconque des revendications 13 à 17, caractérisé en ce que le rouleau applicateur est caoutchouté.
